# EUROPÄISCHE PATENTSCHRIFT

(11) **EP 0 765 110 B1**
(45) Veröffentlichungstag und Bekanntmachung des Hinweises auf die Patenterteilung: **02.06.1999**
(21) Anmeldenummer: 96104392.4
(22) Anmeldetag: 20.03.1996
(51) Int. Cl.: H05K 1/14, H01R 9/09

(54) **Schaltungsplatine sowie Verfahren zum Herstellen einer Schaltungsplatine**
Circuit board and method of making
Plaquette de circuit et son procédé de fabrication

(30) Priorität: 23.09.1995 DE 19535490
(43) Veröffentlichungstag der Anmeldung: 26.03.1997
(73) Patentinhaber: ROBERT BOSCH GMBH, 70442 Stuttgart (DE)
(72) Erfinder: Baur, Peter,Dr., Dipl.-Ing., 71334 Waiblingen (DE); Kazmierczak, Harald, Dipl.-Phys., 71717 Beilstein (DE)

(56) Entgegenhaltungen:
- EP-A- 0 019 836
- WO-A-89/03165
- DE-C- 478 666
- US-A- 4 076 356
- US-A- 4 725 920
- US-A- 5 355 282

## Beschreibung

### Stand der Technik

Die Erfindung betrifft eine Schaltungsplatine sowie ein Verfahren zum Herstellen einer Schaltungsplatine nach der Gattung der unabhängigen Ansprüche. Schaltungsplatinen sind für die unterschiedlichsten Anwendungen bekannt und weisen in der Regel ein Trägersubstrat mit einer in Siebdruck oder über Ätzverfharen hergestellten aufgedruckten Leiterbahnstruktur auf. Die Leiterbahnen verbinden die einzelnen, nachträglich aufgebrachten elektronischen Komponenten, so daß eine elektronische Schaltung entsteht. Diese Art von Schaltungsplatinen sind jedoch nur für niedrige Ströme bis ca 5 A geeignet. Aus dem Dokument US-A-3 867 759 ist der Zusammenbau von Schaltungsplatinen mittels Einsteckstifte oder - Drähte bekannt. Schaltungsplatinen für hohe ströme bis zu 100 A weisen in der Regel eine Leiterbahnstruktur auf, die beispielsweise separat in Stanztechnik hergestellt und auf ein Trägersubstrat aufgeklebt ist (DE-PS 478 666). Werden für eine spezielle Anwendung sowohl hohe als auch niedere ströme benötigt, so werden hierfür gesonderte Platinen hergestellt und über Kabel- und Steckverbindungen elektrisch miteinander verbunden. Es ist auch schon bekannt, die Schaltungsplatinen für hohe und niedere ströme in einem festen definierten Abstand voneinander anzubringen und über feste Drahtbrücken miteinander zu verbinden. Diese Lösungen sind jedoch sehr kostenintensiv und benötigen ein erhöhtes Platzangebot. Außerdem werden durch die freistehenden Drahtbrücken mehr oder weniger kleine Antennen bzw. Schwingkreise erzeugt, über die möglicherweise elektromagnetische Streufelder ein- und/oder ausgekoppelt werden können. Deshalb sind erhebliche Aufwendungen zur Verbesserung der elektromagnetischen Verträglichkeit dieser Schaltungsarten notwendig.

### Vorteile der Erfindung

Die erfindungsgemäße Schaltungsplatine mit den Merkmalen des Hauptanspruchs hat den Vorteil, daß auf einer Schaltungsplatine sowohl Schaltungen, die mit niedrigen Strömen als auch Schaltungen, die mit hohen Strömen betrieben werden, aufgebracht werden können. Ein Verdrahten über längere Strecken zwischen zwei separaten Schaltungsplatinen entfällt. Die elektrische Verbindung wird einfach mittels Steckkontakte erreicht, die durchkontaktiert werden, wobei als Steckkontakte einzelne Stifte oder besonders vorteilhaft die Anschlußbeine für die elektrischen Komponenten der Hochstromschaltung Verwendung finden. Die elektromagnetische Verträglichkeit ist aufgrund der kurzen Leitungen zwischen den Platinenteilen sehr gut; aufwendige Kompensationsschaltungen können entfallen.

Als besonders vorteilhaft hat sich erwiesen, daß durch die Leiterplatte für Hochstrom separate Kühlkörper für Leistungsbauelemente im Niederstrombereich entfallen können, da durch die direkte Ankopplung der beiden Platinen und die gute Wärmeleitung über die Steckkontakte die Wärme direkt von der großflächigen Leiterbahnstruktur im Hochstrombereich abgestrahlt wird.

Durch die in den Unteransprüchen aufgeführten Merkmale sind vorteilhafte Weiterbildungen der Schaltungsplatine nach dem Hauptanspruch möglich. Ist die Trägerplatine aus Glasfaser und/oder Glasfasermatten verstärktem Epoxidharz, so gewährleistet dieses ein gutes Temperaturverhalten mit geringem Wärmeverzug. Ferner weisen die eingepreßten Steckkontakte eine hohe Auszugskraft auf und im Bereich der Einpreßzonen ist durch diese Maßnahme ein Ausreißen verhindert.

In vorteilhafter Weise ist die Hochstromleiterplatte als Leiterbahnstruktur ausgebildet, die durch eine Klebefolie zusammengehalten wird. Dabei kann die Klebefolie auch als Isolierung gegenüber der Trägerplatine oder gegenüber anderen Hochstromleiterplatten dienen. In die Leiterbahnstruktur sind Löcher vorzugsweise eingestanzt, die die Steckkontakte aufnehmen und eine elektrische Verbindung zu den anderen Leiterbahnen bzw. zur Trägerplatine ermöglicht. Die Leiterbahnstruktur ist ebenfalls in vorteilhafter Weise aus Vollmaterial, d.h. aus Blech oder einer Folie gestanzt. Mehrere dieser Hochstromleiterplatten und/oder mehrere Trägerplatinen können vorteilhaft zu einer kompletten Schaltungsplatine vereinigt sein.

Als besonders haltbare elektrische Verbindung haben sich Kontakte mit einem Gewinde erwiesen, wobei die Kontakte bevorzugt kegelförmig zulaufen und ein einer Blechschraube ähnliches Gewinde aufweisen. Diese Maßnahmen bewirken, daß thermische Ausdehnungen nur einen verschwindend geringen Einfluß auf die Kontaktierung besitzen.

Bei einem bevorzugten Verfahren zum Herstellen einer Schaltungsplatine der eingangs genannten Art wird die Leiterbahnstruktur der Hochstromleiterplatte aus einem Blech oder einer Folie ausgestanzt, wobei Stege zwischen den einzelnen Leiterbahnen stehengelassen werden, um diese zusammenzuhalten. Diese Struktur wird auf eine Klebefolie aufgebracht, wonach die Stege ausgestanzt werden können. Nach dem Aufbringen dieser Hochstromleiterplatte auf die Trägerplatine wird diese fixiert und kontaktiert. Das Fixieren kann in vorteilhafter Weise auch direkt durch die Kontaktstifte erfolgen.

Bei einem weiteren Verfahren zum Herstellen der Schaltungsplatine der eingangs genannten Art wird die Klebeschicht auf die Trägerplatine aufgebracht und mit der bereits vorgestanzten, noch mit Stegen versehenen Leiterbahnstruktur der Hochstromplatine verbunden. Danach werden die Stege ausgestanzt und die Platinen durch Durchkontaktieren elektrisch miteinander verbunden.

Die Kontaktstifte und die elektrischen Bauelemente für die Hochstromtechnik werden in vorteilhafter Weise eingepreßt oder eingesteckt und können eine oder mehrere Hochstromleiterplatten und/oder Trägerplatinen elektrisch miteinander verbinden.

### Zeichnung

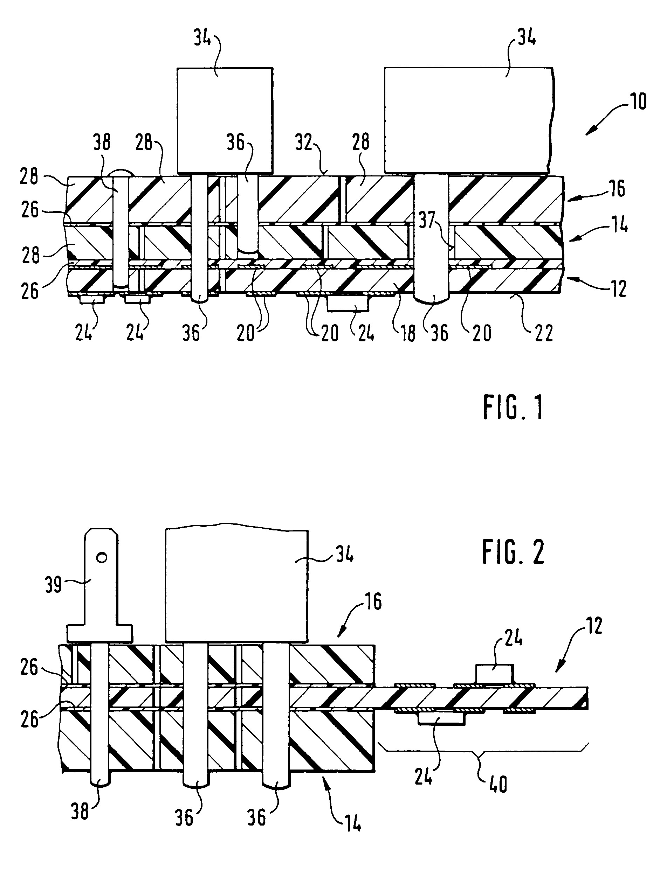

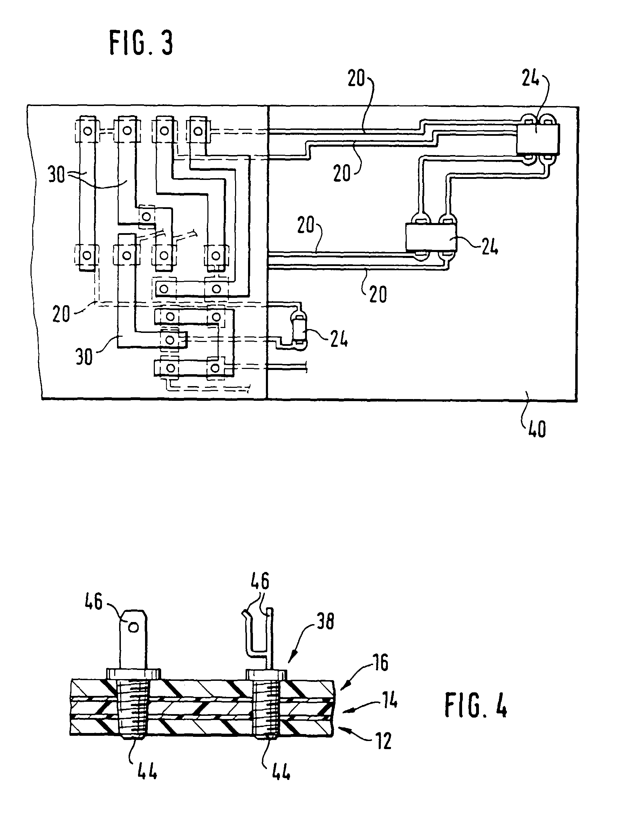

In der Zeichnung sind zwei Ausführungsbeispiele dargestellt und in der nachfolgenden Beschreibung näher erläutert. Es zeigen Figur 1 eine erfindungsgemäße Schaltungsplatine gemäß dem ersten Ausführungsbeispiel im Schnitt, Figur 2 eine erfindungsgemäße Schaltungsplatine nach dem zweiten Ausführungsbeispiel ebenfalls im Schnitt, Figur 3 eine Draufsicht auf eine Schaltungsplatine gemäß Figur 2 und Figur 4 einen Ausschnitt aus einer Schaltungsplatine mit eingebrachten Gewindekontakten ebenfalls im Schnitt.

### Beschreibung

In Figur 1 ist eine Schaltungsplatine 10 gemäß einem ersten Ausführungsbeispiel im Schnitt gezeigt, die eine Trägerplatine 12 und zwei Hochstromplatinen 14 und 16 aufweist. Die Trägerplatine 12 weist einen Grundkörper 18 auf, der beidseitig mit einer Leiterbahnstruktur 20 versehen ist, die beispielsweise durch Siebdruck oder Ätztechnik erzeugt wurden. Diese Leiterbahnstruktur 20 ist ausgelegt für niedrige Ströme, wie sie üblicherweise in elektronischen Schaltungen auftreten.

Auf einer Seite 22 sind elektronische Bauelemente 24 aufgelötet, die über die Leiterbahnstruktur 20 untereinander in Verbindung stehen. Auf der der Seite 22 gegenüberliegenden Seite ist die Hochstromplatine 14 mittels einer Klebefolie 26 fest mit der Trägerplatine 12 verbunden. Auf die der Trägerplatine 12 gegenüberliegenden Seite der Hochstromplatine 14 ist ebenfalls über eine Klebefolie 26 die Hochstromplatine 16 auf der Hochstromplatine 14 aufgebracht.

Die Hochstromplatinen 14 und 16 bestehen aus einzelnen Leiterbahnen 28, die zusammen eine Leiterbahnstruktur 30 bilden (Figur 3). Die einzelnen, voneinander getrennten Leiterbahnen 28 der Hochstromplatine 14 bzw. 16 sind direkt auf die Trägerplatine 12 bzw. auf die Hochstromplatine 14 aufgeklebt. Der Einsatz von Klebefolien 26 verleiht dem gesamten Aufbau einen äußerst stabilen Verbundcharakter.

Auf der Hochstromplatine 16 sind auf der, der Trägerplatine 12 gegenüberliegenden Seite 32 elektrische Bauelemente wie Kondensatoren, Widerstände, Relais usw. aufgebracht. Dazu weisen diese Bauelemente 34 mehr oder weniger lange Beinchen 36 auf, die mit mindestens einer der Platinen 14, 16 oder mit der Leiterbahnstruktur 20 elektrisch verbunden sind.

Die elektrische Verbindung der Beinchen 36 mit den Leiterbahnen 28 und/oder der Leiterbahnstruktur 20 ist durch eine mechanische Verbindung erreicht, die durch Einstecken bzw. ein Einpressen der stiftartigen Beinchen 36 in die Leiterbahnen erreicht wird. Die Auszugsfestigkeit der elektrischen Bauteile 34 kann dadurch erhöht werden, daß mindestens eines der Beinchen 36 in die Trägerplatine 12 eingepreßt ist. Für den Fall, daß eine elektrische Verbindung zu einer bestimmten Leiterbahn nicht gewünscht ist, diese aber von einem Beinchen 36 durchdrungen wird, ist die entsprechende Aussparung 38 größer als der Durchmesser des Beinchens 36. Es ist auch möglich, wenn an einer Stelle keine elektronischen Bauteile 34 aufgebracht sind, für die elektrische Verbindung einen Steckkontakt 38 in Stiftform einzusetzen. Dieser Steckkontakt 38 kann auch eine Anschlußfahen 39 aufweisen oder zusammen mit einem anderen Steckkontakt 38 als Sicherungshalter eingesetzt sein.

Ein weiteres Ausführungsbeispiel gemäß Figur 2, bei dem für gleiche Bauteile gleiche Bezugszahlen verwendet wurden, weist eine Trägerplatine 12 auf, die in ihrer Längserstreckung größer ist als die Hochstromplatinen 14, 16 und in einem Bereich 40 übersteht. Im Bereich der Hochstromplatinen 14, 16 weist die Trägerplatine 12 keine elektronischen Bauteile auf, vielmehr sind die Hochstromplatinen 14, 16 beidseitig auf einander gegenüberliegenden Seiten der Trägerplatine 12 mittels Klebefolien 26 aufgebracht. Die elektronischen Bauteile 24 befinden sich im Bereich 40 und sind dort beidseitig angeordnet. Die Führung der Leiterbahnstruktur 20 sowie der Hochstromleiterbahnstruktur 30 ist in Figur 3 schematisch angedeutet.

Die Trägerplatine 12 ist vorzugsweise aus Glasfaser oder glasfasermatten verstärktem Epoxidharz gefertigt. Hierdurch wird zum einen eine hohe Auszugskraft der Steckkontakte erreicht und zum anderen reißt dieses Material nicht ein, wenn die Einsteckstifte 38 bzw. die Beinchen 36 eingepreßt werden. Außerdem garantiert dieses Material ein gutes Temperaturverhalten, wodurch die Gefahr einer thermischen Schädigung aufgrund unterschiedlichen Wärmeausdehnungen verringert ist.

Als Klebefolien finden vorzugsweise solche Folien Anwendung, auf die zum einen ein gut haftender Klebstoff aufbringbar ist und die zum anderen elektrisch isolierend wirken. Mit dieser Klebefolie 26 lassen sich dann eine oder mehrere Hochstromleiterplatten 14, 16 auf eine oder mehrere Trägerplatinen 12 aufkleben und somit sehr komplexe Strukturen erzeugen. Wie schon erwähnt, fördert die Folie im Gegensatz zu einer als Paste aufgebrachten Klebeschicht den Verbund der kompletten Schaltungsplatine 10, der aufgrund der mehrere Ebenen durchgreifenden Stifte 38 und Beinchen 36 weiter erhöht wird.

Eine Steigerung der Festigkeit und des Zusammenhalts der einzelnen Ebenen 12, 14, 16 sowie der Auszugskraft der Steckkontakte 38 kann durch ein Gewinde 44 im mit den Platten zusammenwirkenden Bereich des Steckkontakts 38 erhöht werden. Der Steckkontakt 38 wird dann in die aufeinander gepreßten Platten 12, 14, 16 eingedreht, wobei sich das Gewinde in den Durchgang der Platten einschneidet. Das Gewinde 44 kann zylinderförmig oder leicht kegelförmig ausgebildet sein. Ferner weisen die Steckkontakte bevorzugt eine oder mehrere Anschlußfahnen 46 auf.

Die Schaltungsplatine 10 wird hergestellt, indem die Leiterbahnstruktur 30 der Hochstromleiterplatten 14, 16 aus einem Blech oder einer Folie ausgestanzt wird, wobei Stege vorgesehen sind, die die einzelnen Leiterbahnen 28 zusammenhalten. Auf diese Struktur wird eine Klebefolie 26 aufgebracht und anschließend die nicht benötigten Stege ausgestanzt. Im weiteren wird dieser Verbund auf die bereits vorbereitete, mit elektronischen Bauelementen versehene Trägerplatine 12 aufgeklebt und die elektrischen Bauelemente 34 aufgesteckt, wobei mittels Steckkontakte 38 und den Beinchen 36 der elektrischen Bauelemente 34 die Platinen 12, 14, 16 kontaktiert und fixiert werden. Die dafür notwendigen Durchbrüche wurden bereits beim ersten oder zweiten Stanzvorgang in die Leiterbahnen 28 eingebracht.

Bei der Herstellung der Schaltungsplatine 10 ist es auch möglich, die Klebefolie 26 auf die bereits vorbereitete Trägerplatine 12 aufzubringen, darauf die bereits ausgestanzte, mit Stegen versehene Leiterbahnstruktur 30 der Hochstromleiterplatinen 14, 16 aufzukleben, die Stege auszustanzen und die Kontaktierung zu vollziehen.

Die Kontaktstifte 38 bzw. die Bauelemente 34 werden entweder nur eingesteckt oder über einen erheblichen Kraftaufwand eingepreßt. Die dafür notwendigen Kräfte liegen beim Einpressen zwischen 400 bis 800 N. Da mehrere Hochstromleiterplatten und/oder Trägerplatinen übereinander gestapelt werden können, muß die Länge der Kontaktstifte 38 bzw. der Beinchen 36 auf die Dicke der Schaltungsplatinen und die Durchmesser auf den zu erwartenden Kraftaufwand beim Einstecken bzw. Einpressen abgestimmt sein.

## Patentansprüche

1. Schaltungsplatine, insbesondere für die Zentralelektrik eines Kraftfahrzeugs, mit einer Trägerplatte (12), die eine Leiterbahnstruktur zum Verbinden elektronischer Bauelemente aufweist, die mit niedrigem Strom betreibbar sind und mit Durchbrüchen zur Aufnahme elektrischer Kontakte, dadurch gekennzeichnet, daß mindestens eine Hochstromleiterplatte (14, 16) für Bauelemente vorgesehen ist, die mit hohem Strom betreibbar sind, auf die die Trägerplatine (12) aufgebracht und mittels Steck-/oder Einpreßkontakten (38) mit der Trägerplatine (12) elektrisch und mechanisch verbunden ist.

2. Schaltungsplatine nach Anspruch 1, dadurch gekennzeichnet, daß die Trägerplatine (12) aus durch Glasfasern oder Glasfasermatte verstärktem Epoxidharz besteht.

3. Schaltungsplatine nach Anspruch 1 oder 2, dadurch gekennzeichnet, daß die Hochstromleiterplatine (14, 16) eine vorzugsweise gestanzte Leiterbahnstruktur aufweist und mit der Trägerplatine (12) mittels einer zwischen der Trägerplatine (12) und der Hochstromleiterplatine (14, 16) angeordneten Klebefolie (26) verbunden ist.

4. Schaltungsplatine nach Anspruch 3, gekennzeichnet durch eine elektrisch isolierende Klebefolie (26).

5. Schaltungsplatine nach einem der Ansprüche 1 bis 4, dadurch gekennzeichnet, daß die Hochstromplatine (14, 16) und die Trägerplatine (12) Steck- und/oder Einpreßkontakte aufnehmende Durchbrüche aufweist.

6. Schaltungsplatine nach einem der vorhergehenden Ansprüche, dadurch gekennzeichnet, daß die Leiterbahnstruktur (30) der Hochstromleiterplatine (14, 16) aus Blech oder Folie ausgestanzt ist.

7. Schaltungsplatine nach einem der vorhergehenden Ansprüche, dadurch gekennzeichnet, daß mehrere Hochstromleiterplatinen (14, 16) und/oder mehrere Trägerplatinen (12) übereinander angeordnet sind.

8. Schaltungsplatine nach einem der vorhergehenden Ansprüche, dadurch gekennzeichnet, daß elektrische Anschlußbeine (36) von auf der Hochstromleiterplatine (14, 16) angeordneten elektrischen Bauelementen (34) die Leiterbahnen (20, 28) der Trägerplatine (12) und der Hochstromleiterplatine (14, 16) elektrisch miteinander verbinden.

9. Schaltungsplatine nach einem der vorhergehenden Ansprüche, dadurch gekennzeichnet, daß Steckkontakte (38) mit einem zylindrisch oder kegelförmigen Gewinde die Leiterbahnen (20, 28) der Trägerplatine (12) und der Hochstromplatine (14, 16) elektrisch miteinander verbinden.

10. Verfahen zum Herstellen einer Schaltungsplatine, insbesondere für die Zentralelektrik eines Kraftfahrzeugs, mit einer Trägerplatine (12), die eine Leiterbahnstruktur zum Verbinden elektronischer Bauelemente aufweist, die mit niedrigen elektrischen Strömen betreibbar sind und mit Durchbrüchen zur Aufnahme elektrischer Kontakte, insbesondere nach einem der vorhergehenden Ansprüche, dadurch gekennzeichnet, daß mindestens eine Hochstromleiterplatte (14, 16) mit einer Leiterbahnstruktur (30) eingesetzt wird, daß die Leiterbahnstruktur (30) aus einem Blech oder einer Folie ausgestanzt wird, wobei Stege vorgesehen sind, die die einzelnen Leiterbahnen (28) zusammenhalten, daß eine Klebefolie (26) auf die ausgestanzte Leiterbahnstruktur (30) aufgebracht wird, daß anschließend die Stege ausgestanzt werden und daß die Leiterbahnstruktur (30) dann auf die Trägerplatine (12) aufgebracht und kontaktiert wird.

11. Verfahren zum Herstellen einer Schaltungsplatine, insbesondere für die Zentralelektrik eines Kraftfahrzeugs, mit einer Trägerplatine (12), die eine Leiterbahnstruktur zum Verbinden elektronischer Bauelemente aufweist, die mit niedrigen elektrischen Strömen betreibbar sind, und mit Durchbrüchen zur Aufnahme elektrischer Kontakte, insbesondere nach einem der vorhergehenden Ansprüche, dadurch gekennzeichnet, daß mindestens eine Hochstromleiterplatine (14, 16) mit einer Leiterbahnstruktur (30) eingesetzt wird, daß die Leiterbahnstruktur (30) aus einem Blech oder einer Folie ausgestanzt wird, wobei Stege vorgesehen sind, die die einzelnen Leiterbahnen (28) zusammenhalten, daß auf die Trägerplatine (12) eine Klebeschicht (26) aufgebracht wird, daß die die Stege aufweisende Leiterbahnstruktur (30) auf die Klebeschicht (26) aufgebracht wird, daß die Stege ausgestanzt werden und daß die Hochstromleiterplatine (14, 16) mit der Trägerplatine (12) kontaktiert wird.

12. Verfahren nach Anspruch 10 oder 11, dadurch gekennzeichnet, daß Kontaktstifte (38) eingesteckt und/oder eingepreßt werden.

13. Verfahren nach einem der Ansprüche 10 bis 12, dadurch gekennzeichnet, daß elektrische Bauelemente (34) mit Anschlußbeinen (36) in Kontaktstellen eingesteckt und/oder eingepreßt werden und eine elektrische Verbindung zwischen unterschiedlichen Leiterbahnen (20, 28) bewirken.

14. Verfahren nach einem der Ansprüche 10 bis 13, dadurch gekennzeichnet, daß mehrere Hochstromleiterplatinen (14, 16) und/oder mehrere Trägerplatinen (12) übereinander gestapelt und kontaktiert werden.

15. Verfahren nach einem der Ansprüche 10 bis 14, dadurch gekennzeichnet, daß ein Gewinde aufweisende elektrische Anschlüsse in Durchbrüche der Schaltungsplatine eingeschraubt werden.

## Claims

1. Circuit board, in particular for the central electrical system of a motor vehicle, having a mounting board (12) which has a conductor-track structure for connecting electronic components which can be operated at low current, and having apertures for accommodating electrical contacts, characterized in that at least one high-current printed circuit board (14, 16) is provided for components which can be operated with high current, to which the mounting board (12) is fitted, and which is electrically and mechanically connected to the mounting board (12) by means of plug-in/or push-in contacts (38) .

2. Circuit board according to Claim 1, characterized in that the mounting board (12) is composed of epoxy resin reinforced by glass fibres or glass-fibre matting.

3. Circuit board according to Claim 1 or 2, characterized in that the high-current printed circuit board (14, 16) has a preferably stamped conductor-track structure, and is connected to the mounting board (12) by means of an adhesive film (26) which is arranged between the mounting board (12) and the high-current printed circuit board (14, 16).

4. Circuit board according to Claim 3, characterized by an electrically insulating adhesive film (26).

5. Circuit board according to one of Claims 1 to 4, characterized in that the high-current board (14, 16) and the mounting board (12) have apertures which accommodate plug-in and/or push-in contacts.

6. Circuit board according to one of the preceding claims, characterized in that the conductor-track structure (30) of the high-current printed circuit board (14, 16) is stamped from sheet metal or foil.

7. Circuit board according to one of the preceding claims, characterized in that a plurality of high-current printed circuit boards (14, 16) and/or a plurality of mounting boards (12) are arranged one above the other.

8. Circuit board according to one of the preceding claims, characterized in that electrical connecting legs (36) from electrical components (34) which are arranged on the high-current printed circuit board (14, 16) electrically connect the conductor tracks (20, 28) on the mounting board (12) and on the high-current printed circuit board (14, 16) to one another.

9. Circuit board according to one of the preceding claims, characterized in that plug-in contacts (38) having a cylindrical or conical thread electrically connect the conductor tracks (20, 28) on the mounting board (12) and on the high-current board (14, 16) to one another.

10. Method for producing a circuit board, in particular for the central electrical system of a motor vehicle, having a mounting board (12) which has a conductor-track structure for connecting electronic components which can be operated at low electrical currents, and having apertures for accommodating electrical contacts, in particular according to one of the preceding claims, characterized in that at least one high-current printed circuit board (14, 16) having a conductor-track structure (30) is used, in that the conductor-track structure (30) is stamped from a metal sheet or a foil, webs being provided which hold the individual conductor tracks (28) together, in that an adhesive film (26) is applied to the stamped-out conductor-track structure (30), in that the webs are then stamped out, and in that the conductor-track structure (30) is then fitted to the mounting board (12) and is made contact with.

11. Method for producing a circuit board, in particular for the central electrical system of a motor vehicle, having a mounting board (12) which has a conductor-track structure for connecting electronic components which can be operated at low electrical currents, and having apertures for accommodating electrical contacts, in particular according to one of the preceding claims, characterized in that at least one high-current printed circuit board (14, 16) having a conductor-track structure (30) is used, in that the conductor-track structure (30) is stamped from a metal sheet or a foil, webs being provided which hold the individual conductor tracks (28) together, in that an adhesive coating (26) is applied to the mounting board (12), in that the conductor-track structure (30) which has the webs is applied to the adhesive coating (26), in that the webs are stamped out, and in that the high-current printed circuit board (14, 16) makes contact with the mounting board (12).

12. Method according to Claim 10 or 11, characterized in that contact pins (38) are inserted and/or are pushed in.

13. Method according to one of Claims 10 to 12, characterized in that electrical components (34) having connecting legs (36) are inserted and/or are pushed into contact points, and produce an electrical connection between different conductor tracks (20, 28).

14. Method according to one of Claims 10 to 13, characterized in that a plurality of high-current printed circuit boards (14, 16) and/or a plurality of mounting boards (12) are stacked one above the other and are made contact with.

15. Method according to one of Claims 10 to 14, characterized in that electrical connections having a thread are screwed into apertures in the circuit board.

## Revendications

1. Plaquette à circuits imprimés, en particulier pour le système électrique central d'un véhicule à moteur, comprenant une plaque de support (12) qui présente une structure de pistes conductrices servant à relier des composants électroniques que l'on peut faire fonctionner avec des courants faibles, et des ajours servant à recevoir des contacts électriques,
caractérisé en ce qu'
on prévoit au moins une plaque (14, 16) de conducteurs pour courants forts pour des composants qui peuvent fonctionner avec des courants forts, plaque (14, 16) sur laquelle on place la plaque de support (12), et on la relie de façon électrique et mécanique à la plaque de support (12) au moyen de contacts enfichés ou enfoncés à la presse (38).

2. Plaquette à circuits imprimés selon la revendication 1,
caractérisée en ce que
la plaque de support (12) est réalisée en résine époxyde renforcée par des fibres de verre ou une natte de fibres de verre.

3. Plaquette à circuits imprimés selon la revendication 1 ou 2,
caractérisée en ce que
la plaque de conducteurs pour courants forts (14, 16) présente une structure de pistes conductrices de préférence estampée, et est reliée à la plaque de support (12) au moyen d'une feuille adhésive (26) qui est disposée entre la plaque de support (12) et la plaque de conducteurs pour courants forts (14, 16).

4. Plaquette à circuits imprimés selon la revendication 3,
caractérisée par
une feuille adhésive électriquement isolante (26).

5. Plaquette à circuits imprimés selon l'une des revendications 1 à 4,
caractérisée en ce que
la plaque pour courants forts (14, 16) et la plaque de support (12) présentent des ajours qui reçoivent des contacts d'enfichage et/ou des contacts enfoncés à la presse.

6. Plaquette à circuits imprimés selon l'une des revendications précédentes,
caractérisée en ce que
la structure de pistes conductrices (30) de la plaque de conducteurs pour courants forts (14, 16) est estampée à partir d'une tôle ou d'une feuille.

7. Plaquette à circuits imprimés selon l'une des revendications précédentes,
caractérisée en ce qu'
on dispose plusieurs plaques (14, 16) de conducteurs pour courants forts et/ou plusieurs plaques de support (12) les unes sur les autres.

8. Plaquette à circuits imprimés selon l'une des revendications précédentes,
caractérisée en ce que
les pattes de raccordement électrique (36) des composants électriques (34) qui sont disposés sur la plaque (14,16) de conducteurs pour courants forts, relient électriquement les unes aux autres les pistes conductrices (20, 28) de la plaque de support (12) et de la plaque de conducteurs pour courants forts (14, 16).

9. Plaquette à circuits imprimés selon l'une des revendications précédentes,
caractérisée en ce que
les contacts à fiches (38) relient électriquement les unes aux autres, par un filetage de forme cylindrique ou de forme conique, les pistes conductrices (20, 28) de la plaque de support (12) et de la plaque pour courants forts (14, 16).

10. Procédé de fabrication d'une plaquette à circuits imprimés, en particulier pour le système électrique central d'un véhicule à moteur, comprenant une plaque de support (12) qui présente une structure de pistes conductrices servant à relier des composants électroniques que l'on peut faire fonctionner avec des courants faibles, et des ajours servant à recevoir des contacts électriques, en particulier selon l'une des revendications précédentes,
caractérisé en ce qu'
- on utilise au moins une plaque de conducteurs pour courants forts (14, 16) avec une structure de pistes conductrices (30),
- la structure de pistes conductrices (30) est estampée à partir d'une tôle ou d'une feuille, des entretoises étant prévues pour maintenir ensemble les différentes pistes conductrices (28),
- on place une feuille adhésive (26) sur la structure estampée de pistes conductrices (30),
- on enlève ensuite par estampage les entretoises, et
- on place ensuite la structure de pistes conductrices (30) sur la plaque de support (12) et on assure les contacts.

11. Procédé de fabrication d'une plaquette à circuits imprimés, en particulier pour le système électrique central d'un véhicule à moteur, comprenant une plaque de support (12) qui présente une structure de pistes conductrices servant à relier des composants électroniques que l'on peut faire fonctionner avec des courants faibles, et des ajours servant à recevoir des contacts électriques, en particulier selon l'une des revendications précédentes,
caractérisé en ce qu'
- on utilise au moins une plaque de conducteurs pour courants forts (14, 16) avec une structure de pistes conductrices (30),
- la structure de pistes conductrices (30) est estampée à partir d'une tôle ou d'une feuille, des entretoises étant prévues pour maintenir ensemble les différentes pistes conductrices (28),
- on place une feuille adhésive (26) sur la plaque de support (12),
- on place la structure de pistes conductrices (30), qui présente les entretoises, sur la couche adhésive (26),
- on enlève par estampage les entretoises, et
- on met en contact la plaque de conducteurs pour courant forts (14, 16) avec la plaque de support (12).

12. Procédé selon la revendication 10 ou 11,
caractérisé en ce qu'
on enfiche et/ou l'on enfonce à la presse les broches de contact (38).

13. Procédé selon l'une des revendications 10 à 12,
caractérisé en ce qu'
on enfiche et/ou l'on enfonce à la presse les composants électriques (34) munis des pattes de raccordement (36), aux emplacements de contact, et l'on réalise une liaison électrique entre différentes pistes conductrices (20, 28).

14. Procédé selon l'une des revendications 10 à 13,
caractérisé en ce que
plusieurs plaquettes de conducteurs pour courants forts (14, 16) et/ou plusieurs plaquettes de support (12) sont empilées les unes sur les autres et mises en contact.

15. Procédé selon l'une des revendications 10 à 14,
caractérisé en ce qu'
on visse des raccords électriques, qui présentent un filetage, dans des ajours de la plaquette à circuits imprimés.
